Europäisches Patentamt

European Patent Office

Office européen des brevets

(19)

(11) Publication number: **0 063 408**
**B1**

# EUROPEAN PATENT SPECIFICATION

(12)

(45) Date of publication of patent specification: **27.12.84**

(51) Int. Cl.³: **H 01 L 23/48**

(21) Application number: **82301300.8**

(22) Date of filing: **15.03.82**

(54) Semiconductor chip carrier.

(30) Priority: **27.03.81 US 248604**
**27.03.81 US 248605**
**14.08.81 US 293023**

(43) Date of publication of application:
**27.10.82 Bulletin 82/43**

(45) Publication of the grant of the patent:
**27.12.84 Bulletin 84/52**

(84) Designated Contracting States:
**BE DE FR GB IT NL**

(56) References cited:
**US-A-3 832 480**
**US-A-4 137 546**

(73) Proprietor: **AMP INCORPORATED**
**P.O. Box 3608 449 Eisenhower Boulevard**
**Harrisburg Pennsylvania 17105 (US)**

(72) Inventor: **Grabbe, Dimitry G.**
**301 Main Street**
**Lisbon Falls Maine 04252 (US)**

(74) Representative: **Gray, Robin Oliver et al**
**BARON & WARREN 18 South End Kensington**
**London W8 5BU (GB)**

Courier Press, Leamington Spa, England.

## Description

This invention relates to a semiconductor chip carrier wherein the inner tips of a lead frame are accurately positioned to permit wire bonding to a semiconductor chip by means of automatic wire bonding machinery.

In the formation of chip carriers, lead frames are normally bonded to a ceramic substrate by well-known methods with subsequent connections being made to the leads of the lead frame from appropriate pads on semiconductor chips secured to the ceramic substrate. These connections from the pads on the chip to the leads of the lead frame are made manually or by means of automatic wire bonding machinery or by mass-bonding techniques using "spider" tape. The automatic wire bonding machinery is normally computer operated on an x—y coordinate basis and it is therefore necessary that the leads of the lead frame be accurately positioned on the substrate so that wiring is run from pads on the semiconductor chip to the appropriate lead on the lead frame.

There is disclosed in US—A—4,141,712 a semiconductor chip carrier of the type comprising a ceramic substrate with a lead frame attached thereto, the lead frame comprising a plurality of leads having outer portions which extend to the edge of the substrate and tip portions proximate to the interior region thereof, the tip portions having integral support means attached thereto.

This carrier requires that an aperture be provided in a package support to which the lead frame is bonded so that the common support for the tip portions may be removed by punching the support out through the aperture in the package support. In an alternative method, discrete tabs are provided which connect groups of substantially non-parallel tip portions. These supports are bent to prevent bonding to the package support and are removed after bonding.

A similar carrier is disclosed in US—A—4,137,546, where the tabs and tip portions overlie a cavity in the substrate.

US—A—4,012,766 discloses support means in the form of a common rim attached to the tip portions, but this is utilized in an injection molded plastic package having an aperture which permits shearing of the rim.

In the above noted known carriers, it is necessary to have an aperture in the member to which the lead frame is attached, where it is desired to have a common support member for the tip portions. The aperture facilitates removal of the support member, but precludes the possibility of bonding a semiconductor chip to the substrate on a common surface with the lead frame. Where tabs connecting tip portions of discrete groups of leads are employed, it is not possible to maintain precise spacing of the groups of leads relative to each other.

The above prior art documents disclosed embedding the leads in a glass composition on the substrate or other conventional process.

According to the invention a semiconductor chip carrier as defined above is characterized in that the support means comprises a common rim overlying the substrate and is spaced therefrom, said interior region being coplanar with the surface of the substrate to which the lead frame is bonded.

The common rim assures that all tip portions are accurately spaced relative to each other during the bonding process. The spacing of the rim from the substrate assures that the rim will not be bonded to the substrate during the bonding process. The rim is removed from the lead frame after bonding of the lead frame to the ceramic substrate, and the semiconductor chip is thereafter bonded to the interior region of the substrate.

It is also desirable that a ground pad be provided in the event the bottom surface of the semiconductor chip is to be maintained at ground potential. The rim can be removed by shearing, pinch cutting, etching, or the like.

Three embodiments of the invention will now be described by way of example with reference to the accompanying drawings, in which:

Figure 1 is a plan view of a first embodiment of a semiconductor chip carrier with the common rim still attached;

Figure 2 is a cross-section of the chip carrier of Figure 1 with a cutting element positioned thereabove;

Figure 3 is a plan view of the chip carrier of Figure 1 after the rim has been removed;

Figure 4 is a cross-section of the chip carrier of Figure 1 after the cutting element has severed the rim;

Figure 5 is a plan view of a second embodiment of a chip carrier with a ground pad attached to the common rim;

Figure 6 is a partial plan view of the chip carrier of Figure 5 after the rim has been removed;

Figure 7 is an enlarged perspective of a portion of the embodiment shown in Figure 5;

Figure 8 is a cross-section of the chip carrier of Figure 5 taken along line 8—8 of Figure 7, showing a cutting edge positioned to sever the rim;

Figure 9 is an enlarged perspective of a portion of the embodiment shown in Figure 6;

Figure 10 is a partial plan view of a third embodiment of a chip carrier having a rim which has extended portions and is bent away from the substrate;

Figure 11 is a cross-section of the chip carrier of Figure 10 with a cutting element positioned thereabove; and

Figure 12 is a cross-section of the chip carrier of Figure 10 after the cutting element has severed the rim.

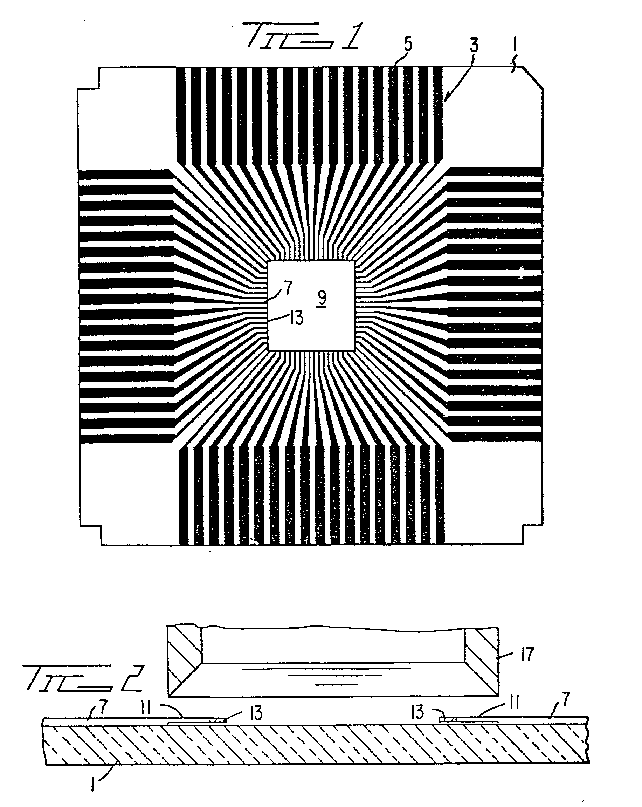

Referring first to Figure 1, there is shown a ceramic substrate 1 which is formed of alumina, beryllia, or other appropriate material.

Positioned on the substrate 1 is a first embodiment of lead frame 3 comprising a plurality of leads having outer portions 5 which extend to the edges of the substrate 1 and tip portions 7 proximate to the interior region 9 of the substrate 1. The tip portions 7 will ultimately be wire bonded to a semiconductor chip which will be bonded to the interior region 9 in known manner. The lead frame 3 is preferably formed of copper or copper-surfaced metal and is oxidized on the surface adjacent the ceramic substrate. The lead frame is then bonded to the ceramic substrate by the procedure described in U.S. Patent Nos. 3,744,120 (Burgess et al), 3,766,634 (Babcock et al), 3,854,892 (Burgess et al), 3,911,553 (Burgess et al), 3,994,430 (Cusano et al), and 4,129,243 (Cusano et al). After firing and bonding the lead frame 3 to the substrate 1, the common support rim 13 is removed. In order to prevent relative movement of the tip portions 7 during the bonding procedure, a common rim 13 is attached to all of the tip portions 7.

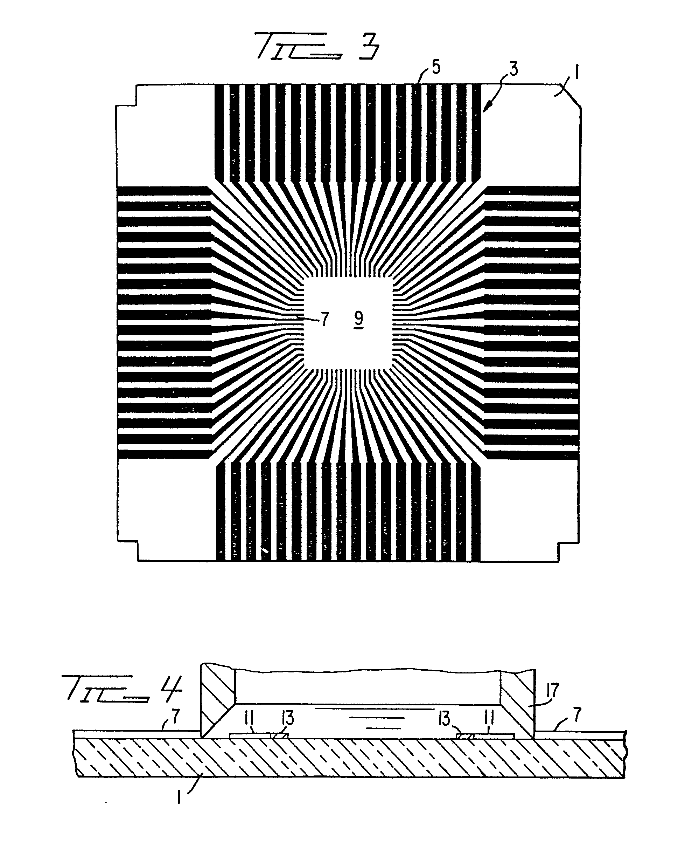

As shown in Figure 2, each tip portion 7 has a reduced thickness portion 11, which is attached to the common support rim 13 which is also of reduced thickness. This configuration prevents the reduced thickness portions 11 of the tip portions 7 and the rim 13 from being in contact with the substrate 1 during the bonding procedure. After the firing takes place which bonds the lead frame 3 to the substrate 1 in accordance with the teachings of the above noted patents, the rim 13 is removed by shearing element 17. The rim 13 may also be removed by pinch cutting, etching, or the like.

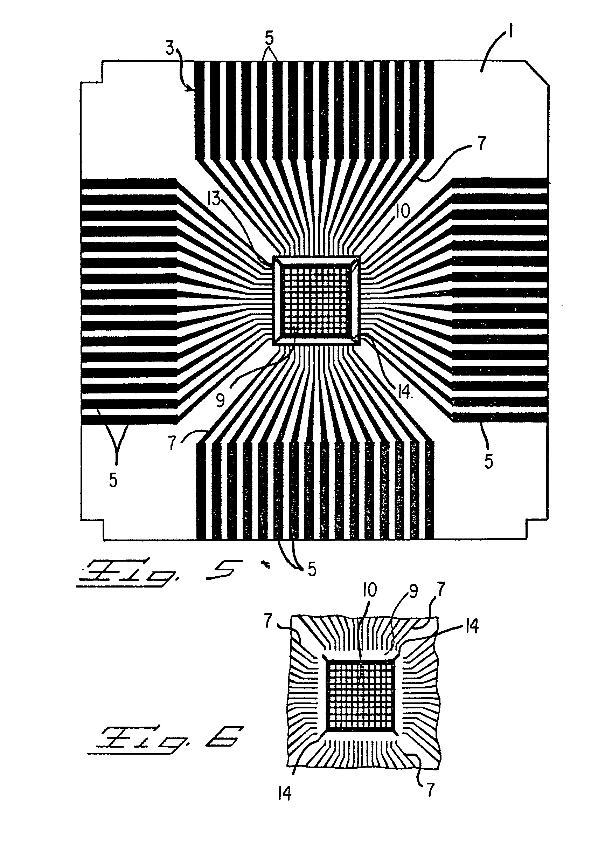

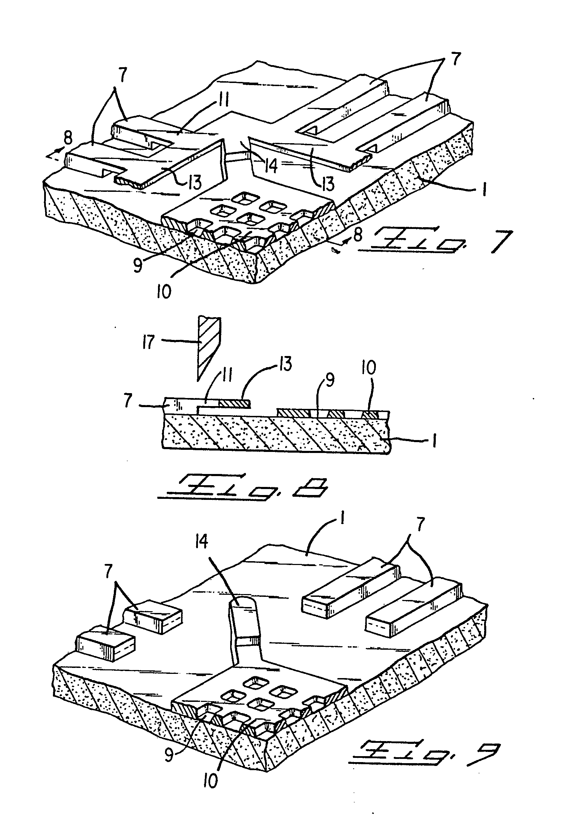

Figure 3 shows the lead frame 3 as bonded to the substrate 1 after the rim 13 (Figure 1) has been removed. The tip portions 7 have the same relative spacing as before firing and are properly positioned and available for bonding of wires thereto by automatic wire bonding machinery. Figure 4 shows a cross-section through Figure 3 after the rim 13 has been severed by the shearing element 17.

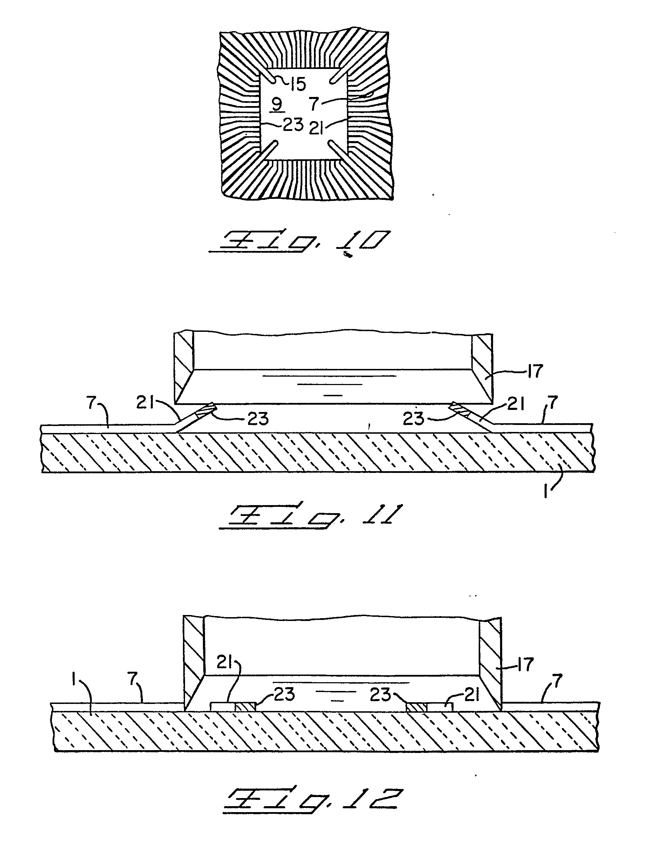

Figure 5 is a plan view of a second embodiment of lead frame 3 which further includes a ground pad 10 attached to support rim 13 by means of tabs 14. As in the first embodiment described in conjunction with Figures 1 through 4, the lead frame 3 and ground pad 10 are formed of copper or copper-surfaced metal and are bonded to the substrate by the procedure described in the above noted patents. The ground pad 10 is in the form of a grid capable of passing gases therethrough which may form during the bonding process. The passage of gas through the grid prevents formation of blisters between the ground pad 10 and the interior region 9. Figure 6 is a partial plan view of the chip carrier after the support rim 13 has been removed.

Figure 7 is a partial perspective showing the tip portions 7 and ground pad 10 as bonded to the substrate, prior to removal of support rim 13. As in the first embodiment described in conjunction with Figure 1 through 4, the tip portions 7 have reduced thickness portions 11, which are integral with common rim 13 which is also of reduced thickness, as are tabs 14. This thickness is about one half that of the remainder of the lead frame excepting the ground pad 10, which is also of reduced thickness. The actual thickness of the temporary support rim 13 is determined by the dimensions of the lead frame 3 involved. As a practical matter, the thickness of the support 13 must be such that it will not sag sufficiently during the bonding procedure to come in contact with the ceramic substrate 1.

Figure 8 depicts a shearing element 17 which will sever the temporary support rim 13 from tabs 14 and the tip portions 7. The resulting lead frame is shown in partial perspective in Figure 9.

Figure 10 is a partial plan view of a third embodiment of a lead frame having tip portions 7 and a common support rim 23 having extended portions 15 which connect substantially non-parallel tip portions 7. The tip portions 7 have raised portions 21 proximate to the rim 23 which prevent the rim 23 from bonding to the substrate 1 when the lead frame is bonded thereto in accordance with the procedure set forth in the above noted patents. The extended portions 15 prevent movement of the tip portions 7 from their initial position as the rim 23 is bent upward from the substrate 1 prior to lead frame attachment. The extended portions 15 undergo deformation which permits an increase in the perimeter of rim 13 which occurs only in the extended portions 15 and is not uniformly distributed around the perimeter. Thus the tip portions 7 will remain in their initial position after bending the rim 23 and will be accurately positioned for subsequent wire bonding.

Figure 11 shows a pinch cutting element 17 prior to severing the temporary support rim 23 and raised portions 21 from the remainder of tip portions 7, which are bonded to the substrate 1. Figure 12 is a similar view to Figure 11 after the rim 23 has been severed, leaving the tip portions 7 suitably positioned for automatic wire bonding.

Several methods have been described whereby lead frames can be positioned on ceramic substrates with the leads on the lead frame retaining their relative positions during the bonding operation, and whereby a ground pad can be provided which is positively positioned relative to the lead frame.

**Claims**

1. A semiconductor chip carrier of the type comprising a ceramic substrate (1) with a lead frame (3) attached thereto, the lead frame (3) comprising a plurality of leads having outer portions (5) which extend to the edge of said substrate and tip portions (7) proximate to the interior region (9) thereof, the tip portions (7) having integral support means attached thereto, characterized in that the support means comprises a common rim (13, 23) overlying the substrate (1) and spaced therefrom, said interior region (9) being coplanar with the surface of the substrate (1) to which the lead frame (3) is bonded.

2. The chip carrier of Claim 1, characterized in that said common rim (13) is coplanar with said lead frame (3), said rim (13) having a thickness which is less than the thickness of said lead frame (3).

3. The chip carrier of Claim 2, characterized by a grounding pad (10) bonded directly to the interior region (9) of said substrate, said grounding pad (10) being connected to said rim (13) by a plurality of tabs (14) integral with said rim (13).

4. The chip carrier of Claim 3, characterized in that said grounding pad (10) is perforated.

5. The chip carrier of Claim 1, characterized in that said rim (23) has extended portions (15) which connect tip portions (7) which are substantially non-parallel, said extended portions (15) having a length greater than the shortest straight line distance between said non-parallel tip portions, said rim (23) being bent to a non-coplanar relationship with said lead frame (3).

6. The chip carrier of Claim 1, characterized in that said ceramic substrate (1) is of alumina or beryllia.

### Patentansprüche

1. Halbleiterchip-Träger des Typs, der ein Keramiksubstrat (1) mit einem daran angebrachten Leiterrahmen (3) umfaßt, wobei der Leiterrahmen (3) eine Mehrzahl von Leitern besitzt, die sich zum Rand des Substrats erstreckende äußere Bereiche (5) sowie Spitzenbereiche (7) in der Nähe des inneren Bereichs (9) des Substrats aufweisen, wobei an den Spitzenbereichen (7) eine einstückige Trageeinrichtung angebracht ist, dadurch gekennzeichnet, daß die Trageeinrichtung einen gemeinsamen Rand (13, 23) umfaßt, der über dem Substrat (1) liegt und von diesem beabstandet ist, und daß der innere Bereich (9) mit derjenigen Oberfläche des Substrats (1) koplanar ist, an die der Leiterrahmen (3) gebondet ist.

2. Chip-Träger nach Anspruch 1, dadurch gekennzeichnet, daß der gemeinsame Rand (13) mit dem Leiterrahmen (3) coplanar ist, wobei der Rand (13) eine Dicke aufweist, die geringer ist als die Dicke des Leiterrahmens (3).

3. Chip-Träger nach Anspruch 2, gekennzeichnet durch eine Masseanschlußfläche (10), die direkt an den inneren Bereich (9) des Substrats gebondet ist, wobei die Masseanschlußfläche (10) durch eine Mehrzahl von einstückig mit dem Rand (13) ausgebildeten Zungen (14) mit dem Rand (13) verbunden ist.

4. Chip-Träger nach Anspruch 1, dadurch gekennzeichnet, daß die Masseanschlußfläche (10) perforiert ist.

5. Chip-Träger nach Anspruch 1, dadurch gekennzeichnet, daß der Rand (23) verlängerte Bereiche (15) aufweist, die im wesentlichen nicht parallele Spitzenbereiche (7) miteinander verbinden, wobei die verlängerten Bereiche (15) eine Länge aufweisen, die größer ist als die kürzeste geradlinige Entfernung zwischen den nicht parallelen Spitzenbereichen und wobei der Rand (23) in nicht-koplanerer Weise in bezug auf den Leiterrahmen (3) umgebogen ist.

6. Chip-Träger nach Anspruch 1, dadurch gekennzeichnet, daß das Keramiksubstrat (1) aus Aluminiumoxid oder Beryllium besteht.

### Revendications

1. Support de puce semi-conductrice du type comprenant un substrat céramique (1) auquel un cadre (3) de montage est attaché, le cadre (3) de montage comprenant plusieurs conducteurs comportant des tronçons extérieurs (5) qui s'étendent jusqu'au bord dudit substrat et des tronçons extrêmes (7) proches de la zone intérieure (9) de celui-ci, les tronçons extrêmes (7) étant solidaires de moyens de support qui leur sont attachés, caractérisé en ce que les moyens de support comprennent un rebord commun (13, 23) s'étendant au-dessus du substrat (1) duquel il est écarté, ladite zone intérieure (9) étant coplanaire avec la surface du substrat (1) à laquelle le cadre (3) de montage est fixé.

2. Support de puce selon la revendication 1, caractérisé en ce que ledit rebord commun (13) est coplanaire avec ledit cadre de montage (3), ledit rebord (13) ayant une épaisseur qui est inférieure à l'épaisseur dudit cadre de montage (3).

3. Support de puce selon la revendication 2, caractérisé par un plot (10) de mise à la masse fixé directement à la zone intérieure (9) dudit substrat, ledit plot (10) de mise à la masse étant connecté audit rebord (13) par plusieurs languettes (14) réalisées d'une seule pièce avec ledit rebord (13).

4. Support de puce selon la revendication 3, caractérisé en ce que ledit plot (10) de mise à la masse est perforé.

5. Support de puce selon la revendication 1, caractérisé en ce que ledit rebord (23) comporte des prolongements (15) qui sont reliés à des tronçons extrêmes (7) qui ne sont sensiblement pas parallèles, lesdits prolongements (15) ayant une longueur supérieure à la distance la plus courte, en ligne droite, entre lesdits tronçons extrêmes non parallèles, ledit rebord (23) étant plié de façon à n'être pas coplanaire avec ledit cadre (3) de montage.

6. Support de puce selon la revendication 1, caractérisé en ce que ledit substrat céramique (1) est en alumine ou en oxyde de béryllium.

FIG. 1

FIG. 2

Fig. 3

Fig. 4

Fig. 5

Fig. 6

Fig. 7

Fig. 8

Fig. 9

Fig. 10

Fig. 11

Fig. 12